# EUROPEAN PATENT APPLICATION

(11) **EP 1 014 519 A2**
(43) Date of publication of application: **28.06.2000**
(21) Application number: 99125805.4
(22) Date of filing: 23.12.1999
(51) Int. Cl.: H01S 5/022

(54) **Semiconductor laser module**

(30) Priority: 25.12.1998 JP 36880898
(71) Applicant: NEC CORPORATION, Tokyo (JP)
(72) Inventor: Kosugi, Tomonari, Minato-ku, Tokyo (JP)
(74) Representative: Glawe, Delfs, Moll & Partner

(57) **Abstract**

A semiconductor laser module which enables reliability to be improved while preventing defect that when solder bonds the substrate mounting the semiconductor laser to the electronic cooler, flowing solder flows into the electronic cooler, thus the electronic cooler does not function caused by the short circuit. There is provided a cylindrical insulator made of ceramics such as forsterite and so forth for surrounding an electronic cooling element on an upper-surface substrate and a lower-surface substrate which put the electronic cooling element therebetween. It prevents the defect that excessive solder flows into the electronic cooling element in the case where the lower-surface substrate is soldered to the module package, or when a substrate mounting the semiconductor laser is soldered to the upper-surface substrate.

## Description

### BACKGROUND OF THE INVENTION

The present invention relates to a semiconductor laser module. More to particularly, this invention relates to a semiconductor laser module which is provided with an electronic cooler for cooling a semiconductor laser.

### Description of the Prior Art

The semiconductor laser module is used widely as signal light source which is used for an optical fiber transmission device and so forth. The transmission device using the optical fiber tends to be miniaturized and to have high reliability. Various kinds of parts such as the semiconductor laser module and so forth which are integrated in a circuit substrate of the transmission device described-above are also required similarly to have property of high reliability and miniaturization.

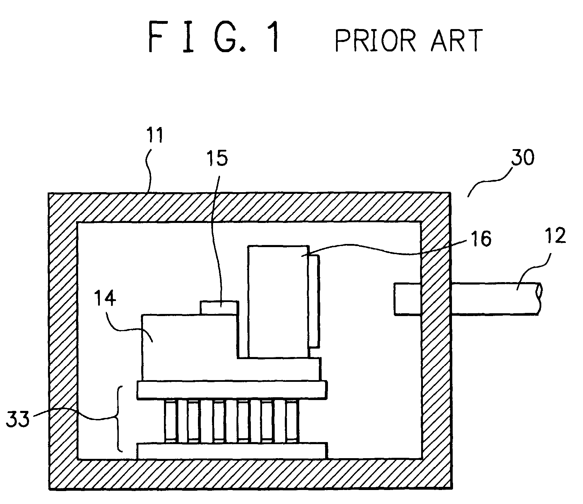

Here, there is described a structure of conventional semiconductor laser module referring to Fig. 1. Fig. 1 is a cross sectional view observed from the side of conventional semiconductor laser module. One end of an optical fiber 12 for transmitting optical signal is contained in one side wall of a module package 11 of the semiconductor laser module 30. An electronic cooler 33 is arranged on the inside bottom of the module package 11. The semiconductor laser 15 and a lens 16 which causes light beam emitted from the semiconductor laser to be optically combined with the optical fiber 12 are arranged on the electronic cooler 33 through a substrate 14.

In the semiconductor laser module 30, the substrate 14 and the electronic cooler 33 which are arranged on the semiconductor laser 15 are miniaturized to the limit that semiconductor laser 15 is capable of being cooled to the required temperature. However, it is necessary to increase coupling intensity of solder while securing largely solder coupling surface between the electronic cooler 33 and the substrate 14 for the sake of improvement of cooling efficiency of the semiconductor laser 15 and achievement of high reliability for solder coupling part.

Thus, it is necessary to enlarge coupling surface while causing shape of the substrate 14 to be about the same shape as that of the electronic cooler 33 in order to achieve high reliability and miniaturization of the semiconductor laser module 30. However, at the time of fixing by solder between top-surface of the electronic cooler 33 and undersurface of the substrate 14, the solder flowing from gap between the top-surface of the cooler 33 and the undersurface of the substrate 14 becomes easy to flow into the electronic cooler caused by scrubbing work of solder and so forth so that there occurs problem that the electronic cooler 33 does not function because of suffering from short circuit.

### SUMMARY OF THE INVENTION

In view of the foregoing, it is an object of the present invention, in order to overcome the above-mentioned problem to provide a semiconductor laser module which enables reliability to be improved while preventing defect that when solder bonds the substrate mounting the semiconductor laser to the electronic cooler, flowing excessive solder flows into the electronic cooler, thus the electronic cooler does not function caused by the short circuit.

According to a first aspect of the present invention, in order to achieve the above-mentioned object, there is provided an electronic cooler for cooling a cooled member in such a way that there are provided substrates so as to put an electronic cooling element therebetween while coupling the cooled member to the substrates by solder, wherein there is provided a cylindrical member surrounding the electronic cooling element for the substrates mounted on the electronic cooling element, such that, at the time of coupling, excessive solder does not flow into the electronic cooling element.

According to a second aspect, in the first aspect, there is provided an electronic cooler, wherein the cylindrical member is made of ceramics.

According to a third aspect of the present invention, there is provided a semiconductor laser module which cools a semiconductor laser mounted on a substrate by an electronic cooler consisting of an electronic cooling element and an upper plate and a lower plate arranged so as to put the electronic cooling element therebetween, provides a cylindrical insulating member surrounding at least a part of the electronic cooling element on at least either the upper plate or the lower plate.

According to a fourth aspect of the present invention, there is provided a semiconductor laser module which cools a semiconductor laser mounted on a substrate by an electronic cooler consisting of an electronic cooling element and an upper plate and a lower plate arranged so as to put the electronic cooling element therebetween, provides a cylindrical insulating member for covering the electronic cooling element between the upper plate and the lower plate.

According to a fifth aspect of the present invention, in the third or fourth aspects, there is provided a semiconductor laser module, wherein the cylindrical insulating member is made of ceramics.

According to a sixth aspect of the present invention, in the third or fourth aspect, there is provided a semiconductor laser module, wherein the cylindrical insulating member is made of forsterite.

As described above, according to the above described constitution, the present invention is capable of facilitating manufacturing method of the semiconductor laser module, because it is capable of avoiding short circuit of the electronic cooling element while preventing solder from flowing into the electronic cooling element at the time of fixing of the electronic cooler and the substrate by solder.

The above and further objects and novel features of the invention will be more fully understood from the following detailed description when the same is read in connection with the accompanying drawings. It should be expressly understood, however, that the drawings are for purpose of illustration only and are not intended as a definition of the limits of the invention.

### BRIEF DESCRIPTION OF THE DRAWINGS

Fig. 1 is a side cross sectional view for explaining conventional semiconductor laser module;
Fig. 2 is a perspective view for explaining structure of the semiconductor laser module according to a first embodiment of the present invention;
Fig. 3 is a side cross sectional view for explaining the semiconductor laser module according to the first embodiment of the present invention;
Fig. 4 is a top plan view for explaining the semiconductor laser module according to the first embodiment of the present invention; and
Fig. 5 is a side cross sectional view for explaining a semiconductor laser module according to a second embodiment of the present invention.

### DETAILED DESCRIPTION OF THE PREFERRED EMBODIMENTS

In a configuration of one enforcement, a semiconductor laser module according to the present invention is provided with a cylindrical insulator made of ceramics such as forsterite for surrounding electronic cooling element on a upper-surface substrate and on a lower-surface substrate, which the electronic cooling element intervenes therebetween. Thus the cylindrical insulator prevents defect that excessive solder flows into the electronic cooling element, when the lower-surface substrate is soldered to the module package, or when a substrate on which the semiconductor laser is mounted is soldered to the top-surface substrate.

Preferred embodiments of the present invention will be described in detail in accordance with the accompanying drawings.

### [FIRST EMBODIMENT]

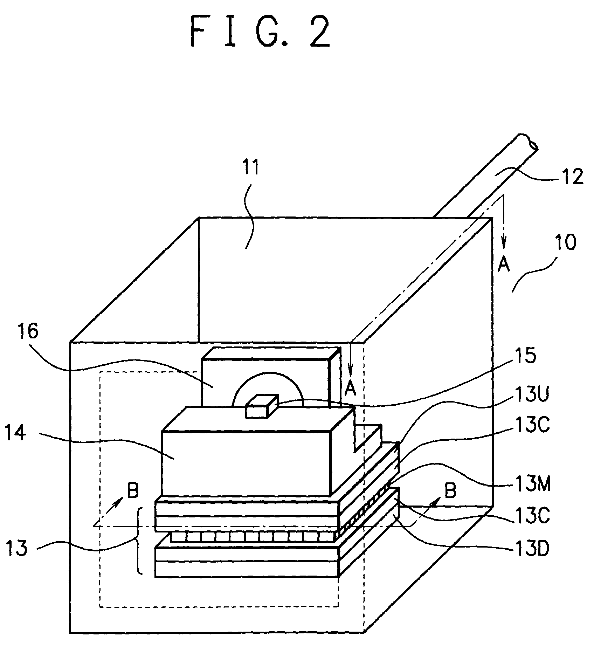

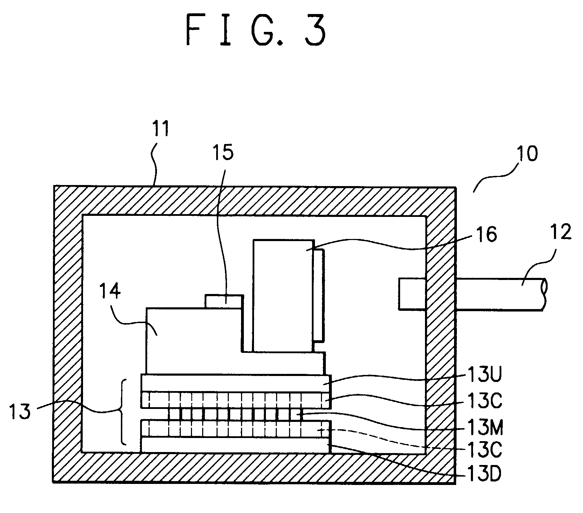

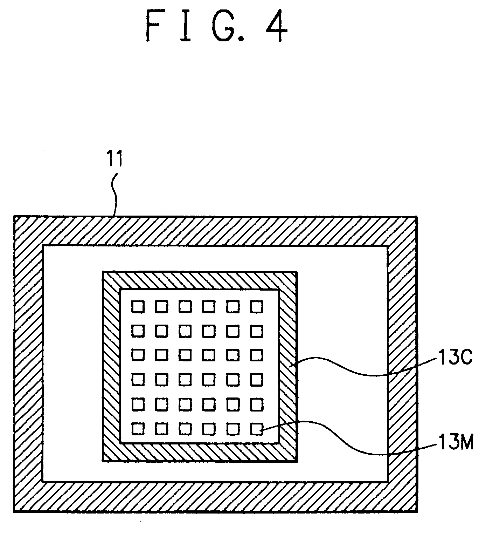

There will be described a first embodiment of the present invention referring to Figs. 2 to 4. Fig. 2 is a perspective view for explaining structure of a semiconductor laser module according to the first embodiment of the present invention. Fig. 3 is a cross sectional view along A-A surface of Fig. 2. Fig. 4 is a cross sectional view along B-B surface of Fig. 2.

Firstly, there will be described a structure of the semiconductor laser module according to the first embodiment referring to Figs. 2 to 4. One end of an optical fiber 12 for transmitting optical signal is fixed to one side wall of a module package 11 of a semiconductor laser module 10 by YAG-welding. An electronic cooler 13 consisting of an electronic cooling element 13M constituted by Peltier-element and so forth, and an upper-surface substrate 13U and a lower-surface substrate 13D is fixed by solder on inside bottom of a module package 11. A cylindrical insulator 13C made of the quality of the material of ceramics and so forth such as forsterite and so forth with small thermal conductivity is fixed to the upper-surface substrate 13U and the lower-surface substrate 13D at the circumference of the electronic cooling element 13M so as to surround the electronic cooling element 13M. Furthermore, the insulator 13C which is fixed to undersurface of the upper-surface substrate 13U of the electronic cooler 13 does not come into contact with the insulator 13C which is fixed to top-surface of the lower-surface substrate 13D.

Further, a substrate 14 made of metallic plate is fixed to top-surface of the electronic cooler 13 by solder. A semiconductor laser 15 is fixed to top-surface of the substrate 14 by solder. A fixed position of the optical fiber 12 is set beforehand in such a way that optic axis of the optical fiber 12 agrees with height of emission part of the semiconductor laser 15. A lens 16 is fixed to the top-surface of the substrate 14 by YAG-welding.

In such the constitution of the semiconductor laser module 10, the semiconductor laser 15 is optically coupled to the optical fiber 12 by the lens 16. The semiconductor laser module 10 has structure that heat generated at the semiconductor laser 15 is radiated by the electronic cooler 13 through the substrate 14, by virtue thereof, temperature of the semiconductor laser 15 is kept during required temperature limit.

In the semiconductor laser module 10 of the present embodiment, at outer periphery of the electronic cooling element 13M, there are provided the cylindrical insulators 13C for undersurface of the upper-surface substrate 13U of the electronic cooler 13 and top-surface of the lower-surface substrate 13D respectively. It is, therefore, capable of preventing defect that excessive solder flows into the electronic cooling element 13M when the electronic cooler 13 is fixed to the substrate 14 by solder, and when the electronic cooler 13 is fixed to the module package 11 by solder. Thus it is capable of being avoided that the electronic cooling element 13M undergoes short circuit by the solder. Consequently, it is capable of facilitating manufacturing process of the semiconductor laser module 10, and of preventing occurrence of inferior goods.

Further, in the present embodiment, there is described cylindrical structure made of the quality of material such as ceramics with small thermal conductivity as the insulator 13C which is fixed on the undersurface of the upper-surface substrate 13U and on the top-surface of the lower-surface substrate 13D by solder. However, the present invention is not restricted by the above-mentioned embodiment. Shape and thickness of the insulator 13C are capable of being changed appropriately according to shape of the upper-surface substrate 13U of the electronic cooler 13, the lower-surface substrate 13D, and the electronic cooling element 13M. The ceramics and so forth with small thermal conductivity such as forsterite and so forth are appropriate for the quality of material of the insulator 13C. However, it is capable of changing the quality of material of the insulator 13C in accordance with required cooling ability.

### [SECOND EMBODIMENT]

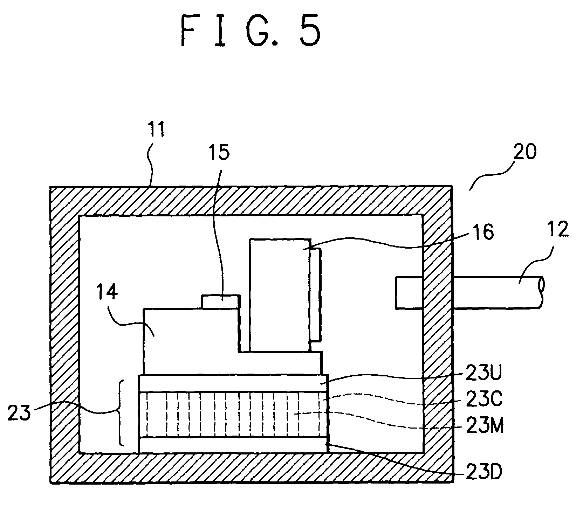

Next, there will be explained a semiconductor laser module according to a second embodiment of the present invention referring to Fig. 5. Fig. 5 is a side cross sectional view showing structure of the semiconductor laser module according to the second embodiment of the present invention. Further, in the present embodiment, there is described the case where the insulator mounted on outer side of the electronic cooling element has different shape from the first embodiment described-above.

A fundamental constitution of the semiconductor laser module according to the present embodiment is the same as that of the first embodiment. One end of an optical fiber 12 for transmitting optical signal is fixed to one side wall of a module package 11 of a semiconductor laser module 20 by YAG-welding. An electronic cooler 23 consisting of an electronic cooling element 23M constituted by Peltier-element and so forth, and an upper-surface substrate 23U and a lower-surface substrate 23D are fixed by solder on inside bottom of a module package 11. Further a substrate 14 made of metallic plate is fixed to top-surface of the electronic cooler 23 by solder. A semiconductor laser 15 is fixed to the substrate 14 by solder.

A fixed position of the optical fiber 12 is set beforehand in such a way that optic axis of the optical fiber 12 agrees with height of emission part of the semiconductor laser 15. A lens 16 is fixed to the top-surface of the substrate 14 by YAG-welding. In such the constitution of the semiconductor laser module 10, the semiconductor laser 15 is optically coupled to the optical fiber 12 by the lens 16. Further, the semiconductor laser module 10 has structure that heat generated at the semiconductor laser 15 is radiated by the electronic cooler 13 through the substrate 14, by virtue thereof, temperature of the semiconductor laser 15 is kept during required temperature limit.

As shown in Fig. 5, the semiconductor laser module 20 of the present embodiment has the constitution that the insulator 23C which is coupled to be integrated two insulators 13C in the first embodiment described above is fixed to undersurface of the upper-surface substrate 23U and top-surface of the lower-surface substrate 23D, so that the electronic cooling element 13M is surrounded completely by the insulator 23C, the upper-surface substrate 23U, and the lower-surface substrate 23D.

In such the structure of the semiconductor laser module 20, the upper-surface substrate 23U of the electronic cooler 23 is coupled to the lower-surface substrate 23D through the insulator 23C, thereby, cooling ability of the module is inferior in comparison with the semiconductor laser module 10 according to the first embodiment described-above. However, there is the merit that it is capable of preventing completely the solder from flowing into the electronic cooling element 13M at the time of soldering. Thus, it is capable of using this semiconductor laser module in answer to required cooling ability.

Furthermore, in the semiconductor laser module 20 of the structure of the present embodiment, it is capable of being avoided the defect that the electronic cooling element 23M undergoes short circuit by the solder. Consequently, it is capable of facilitating manufacturing process of the semiconductor laser module 20, similar to the semiconductor laser module 10 of the first embodiment described above.

As described above, according to the present invention, in the electronic cooler to be constitution part of the semiconductor laser module, there is provided the cylindrical insulator so as to surround the electronic cooling element, made of ceramics and so forth with small thermal conductivity such as forsterite and so forth, for the upper-surface substrate and the lower-surface substrate. It is, therefore, capable of preventing defect that excessive solder flows into the electronic cooling element when the electronic cooler 13 is fixed to the substrate by solder, and when the electronic cooler is fixed to the module package by solder. Thus it is capable of being avoided that the electronic cooling element undergoes short circuit by the solder.

Namely, fixing by solder between the electronic cooler and the substrate or between the electronic cooler and the module package becomes easy so that it is capable of facilitating manufacturing process of the semiconductor laser module, thus the time for manufacturing the semiconductor laser module is reduced, consequently, it is capable of contributing reduction of cost of the semiconductor laser module.

Further, solder does not flow into the electronic cooling element, therefore, it is capable of executing scrubbing of solder effectively. Thus it is capable of improving reliability of fixed part by solder between the electronic cooler and the substrate, and reliability of fixed part by solder between the electronic cooler and the module package.

Furthermore, even though the electronic cooler is soldered to the substrate in such a way that it causes the area of the top-surface of the electronic cooler to be identical with the area of the undersurface of the substrate, the solder does not flow into the electronic cooling element fixed between the upper-surface substrate and the lower-surface substrate, therefore, since it is capable of enlarging solder coupling surface between the top-surface of the electronic cooler and the undersurface of the substrate, there is the effect that it is capable of improving reliability fixed part by solder between the electronic cooler and the substrate caused by increase of coupling intensity of solder.

While preferred embodiments of the invention have been described using specific terms, the description has been for illustrative purposes only, and it is to be understood that changes and variations may be made without departing from the spirit or scope of the following claims.

The term "cylindrical member" as used in this description and in the claims does not necessarily mean a circular shape. Rather, the expression cylindrical member is meant to define any ring-shaped or frame-shaped member that forms a wall surrounding an inner space in which one or more electronic cooling elements may be arranged. In particular, the expression cylindrical member is meant to include frame-shaped members of square shape, as shown in Fig. 4, or any other shape such as rectangular, polygonal, circular or irregular.

## Claims

1. An electronic cooler for cooling a cooled member in such a way that there are provided substrates so as to put an electronic cooling element therebetween while coupling said cooled member to said substrates by solder, wherein there is provided a cylindrical member surrounding said electronic cooling element for said substrates mounted on said electronic cooling element, such that, at the time of coupling, excessive solder does not flow into said electronic cooling element.

2. An electronic cooler as claimed in claim 1, wherein said cylindrical member is made of ceramics.

3. A semiconductor laser module which cools a semiconductor laser mounted on a substrate by an electronic cooler consisting of an electronic cooling element and an upper plate and a lower plate arranged so as to put said electronic cooling element therebetween, provides a cylindrical insulating member surrounding at least a part of said electronic cooling element on at least either said upper plate or said lower plate.

4. A semiconductor laser module which cools a semiconductor laser mounted on a substrate by an electronic cooler consisting of an electronic cooling element and an upper plate and a lower plate arranged so as to put said electronic cooling element therebetween, provides a cylindrical insulating member for covering said electronic cooling element between said upper plate and said lower plate.

5. A semiconductor laser module as claimed in claim 3, wherein said cylindrical insulating member is made of ceramics.

6. A semiconductor laser module as claimed in claim 4, wherein said cylindrical insulating member is made of ceramics.

7. A semiconductor laser module as claimed in claim 3, wherein said cylindrical insulating member is made of forsterite.

8. A semiconductor laser module as claimed in claim 4, wherein said cylindrical insulating member is made of forsterite.
